# EUROPEAN PATENT SPECIFICATION

(11) **EP 4 548 131 B1**
(45) Date of publication and mention of the grant of the patent: **30.09.2026**
(21) Application number: 23758129.3
(22) Date of filing: 01.08.2023
(51) Int. Cl.: G01V 1/28, G01V 1/32

(54) **GENERATING REALISTIC SYNTHETIC SEISMIC DATA ITEMS**
ERZEUGUNG REALISTISCHER SYNTHETISCHER SEISMISCHER DATENELEMENTE
GÉNÉRATION D'ÉLÉMENTS DE DONNÉES SISMIQUES SYNTHÉTIQUES RÉALISTES

(30) Priority: 03.08.2022 US 202263394787 P
(43) Date of publication of application: 07.05.2025
(60) Divisional application: 26193464.0 / 4 811 007
(73) Proprietor: X Development LLC, Mountain View, CA 94043 (US)
(72) Inventor: GONCHARUK, Artem, Mountain View, California 94043 (US); PHAM, Nam Phuong, Austin, Texas 78703 (US); LOOI, Shiang Yong, Mountain View, California 94043 (US); FARRIS, Stuart, Mountain View, California 94043 (US); CLAPP, Robert, Mountain View, California 94043 (US)
(74) Representative: Chettle, John Edward
(86) International application number: PCT/US2023/029200
(87) International publication number: WO 2024/030422

(56) References cited:
- US-A1- 2021 158 104
- OVCHARENKO OLEG ET AL: "Surface-related multiple elimination through orthogonal encoding in the latent space of convolutional autoencoder", FIRST INTERNATIONAL MEETING FOR APPLIED GEOSCIENCE & ENERGY EXPANDED ABSTRACTS, 1 September 2021 (2021-09-01), pages 1355 - 1359, XP093091739, DOI: 10.1190/segam2021-3578561.1
- AHMED M ALAA ET AL: "How Faithful is your Synthetic Data? Sample-level Metrics for Evaluating and Auditing Generative Models", ARXIV.ORG, CORNELL UNIVERSITY LIBRARY, 201 OLIN LIBRARY CORNELL UNIVERSITY ITHACA, NY 14853, 13 July 2022 (2022-07-13), XP091269625
- XINMING WU ET AL: "FaultSeg3D: Using synthetic data sets to train an end-to-end convolutional neural network for 3D seismic fault segmentation", GEOPHYSICS, vol. 84, no. 3, 1 May 2019 (2019-05-01), US, pages IM35 - IM45, XP055600340, ISSN: 0016-8033, DOI: 10.1190/geo2018-0646.1
- SHMELKOV KONSTANTIN ET AL: "How Good Is My GAN?", 9 October 2018, 20181009, PAGE(S) 218 - 234, XP047635934
- LIU MINGLIANG ET AL: "Seismic facies classification using supervised convolutional neural networks and semisupervised generative adversarial networks", GEOPHYSICS, vol. 85, no. 4, 10 June 2020 (2020-06-10), US, pages O47 - O58, XP055950859, ISSN: 0016-8033, DOI: 10.1190/geo2019-0627.1

## Description

### BACKGROUND

This specification relates to simulation and analysis of seismic surveys.

A seismic survey uses seismic waves to create seismic data items (e.g., seismic images) of the earth through analysis of vibrations from those seismic waves. The seismic survey can predict subsurface discontinuities (e.g., faults), layering, probable rock structures, etc. The seismic survey is conducted by deploying an array of energy sources and an array of receivers in an area of interest. The array of energy sources can be dynamite, a specialized air gun or a seismic vibrator. The energy that travels within the subsurface of the earth are the seismic waves, and the seismic waves are recorded at specific locations on the surface of the earth by the receivers (e.g., geophones or hydrophones).

A seismic survey simulation uses a synthetic seismic data generator that models the earth properties to generate synthetic seismic images that simulate the seismic images from real seismic surveys. Because the seismic surveying process can be complicated and the subsurface geology can be complex, it is difficult to generate realistic synthetic seismic images, especially for a three-dimensional (3D) seismic survey.

"Surface-related multiple elimination through orthogonal encoding in the latent space of convolutional autoencoder" (O. Ovcharenko et al., First International Meeting for Applied Geoscience & Energy Expanded Abstracts, Sep 2021) discloses an end-to-end workflow for generation of realistic synthetic seismic data sufficient for knowledge transfer from training on synthetic to inference on field data.

"How Faithful is your Synthetic Data? Sample-level Metrics for Evaluating and Auditing Generative Models" (A. Alaa et al., arXiv:2102.08921v2) discloses a 3-dimensional metric, (α-Precision, β-Recall, Authenticity), that characterizes the fidelity, diversity and generalization performance of any generative model in a wide variety of application domains. The sample-level nature of the metric inspires a novel use case called model auditing, wherein the quality of individual samples is judged generated by a (black-box) model, discarding low-quality samples and hence improving the overall model performance in a post-hoc manner.

### SUMMARY

This specification describes systems and techniques for generating realistic synthetic seismic data items and training a seismic data analysis model on the realistic synthetic seismic data items.

In general, one innovative aspect of the subject matter described in this specification can be embodied in computer-implemented methods that include the actions of obtaining a plurality of synthetic seismic data items, wherein each synthetic seismic data item has been generated with a respective combination of values for one or more parameters of a synthetic seismic data generator, wherein the one or more parameters of the synthetic seismic data generator comprise geological parameters; obtaining a plurality of real seismic data items; processing each of the plurality of synthetic seismic data items using a machine learning model, wherein the machine learning model is configured to process an input seismic data item to generate an embedding; processing each of the plurality of real seismic data items using the same machine learning model; determining a range for the values for the one or more parameters by comparing the synthetic seismic data items and the real seismic data items in an embedding space of the machine learning model; and selecting, as realistic synthetic seismic data items, a plurality of synthetic seismic data items that have been generated with a respective combination of values for the one or more parameters that is within the determined range. Other embodiments of this aspect include corresponding computer systems, apparatus, and computer programs recorded on one or more computer storage devices, each configured to perform the actions of the methods. For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

The foregoing and other embodiments can each optionally include one or more of the following features, alone or in combination. In particular, one embodiment includes all the following features in combination. Selecting, as the realistic synthetic seismic data items, the plurality of synthetic seismic data items that have been generated with the respective combination of values for the one or more parameters that is within the determined range include: selecting, as the realistic synthetic seismic data items, from the obtained plurality of synthetic seismic data items, the plurality of synthetic seismic data items that have been generated with the respective combination of values for the one or more parameters that is within the determined range. Selecting, as the realistic synthetic seismic data items, the plurality of synthetic seismic data items that have been generated with the respective combination of values for the one or more parameters that is within the determined range includes: generating, as the realistic synthetic seismic data items, new synthetic seismic data items using the synthetic seismic data generator by setting the respective combination of values for the one or more parameters within the determined range. Determining the range for the values of the one or more parameters includes determining the range, wherein a distance between an embedding of a synthetic seismic data item generated with a respective combination of values for the one or more parameters that is within the range and an embedding of a real seismic data item is smaller than a threshold. Determining the range for the values for the one or more parameters includes determining the range based on one or more earth properties of the plurality of real seismic data items. The actions further include, before processing each of the plurality of real seismic data items using the machine learning model, processing the plurality of real seismic data items such that the plurality of real seismic data items appear to be data items drawn from a distribution of synthetic seismic data items, wherein the processing comprises:perform a signal or image processing process to remove noise; applying an operator to straighten lines in the real seismic data items; performing a signal processing operation to reduce amplitude variations in the real seismic data items; and/or minimizing or eliminating migration artifacts in the real seismic data items. The actions further include, before processing each of the plurality of synthetic seismic data items using the machine learning model, processing the plurality of synthetic seismic data items such that the plurality of synthetic seismic data items appear to be data items drawn from a distribution of real seismic data items, wherein the processing comprises: migrating the synthetic seismic data items by using realistic apposition parameters; performing image processing or computer vision algorithms on the synthetic seismic data items to add noise, change noise pattern, or add artifacts; and/or using a neural network that has been trained to make a synthetic seismic data item look like a real seismic data item. The actions further include training a seismic data analysis model on the realistic synthetic seismic data items, wherein the realistic synthetic seismic data items generated by the synthetic seismic data generator are associated with respective labels. The seismic data analysis model analyzes one or more earth properties, including: faults, channels, facies, and horizons. The actions further include training the seismic data analysis model on: (i) the realistic synthetic seismic data items and the respective labels; and (ii) a plurality of real seismic data items, wherein the plurality of real seismic data items do not have labels. The actions further include training the machine learning model using the plurality of the synthetic seismic data items and the plurality of real seismic data items. The machine learning model is an encoder of an autoencoder, wherein the autoencoder includes the encoder that processes the input seismic data item to generate the embedding, and a decoder that processes the embedding to regenerate the input seismic data item. Selecting, as the realistic synthetic seismic data items, the plurality of synthetic seismic data items that have been generated with the respective combination of values for the one or more parameters that is within the determined range includes: selecting the plurality of synthetic seismic data items using a reinforcement learning model.

In general, another innovative aspect of the subject matter described in this specification, and not defined in the appended claims, can be embodied in methods that include the actions of generating a plurality of data item pairs that each includes a first synthetic seismic data item and a second synthetic seismic data item, the generating including, for each data item pair: generating the first synthetic seismic data item that simulates a real seismic survey of a region of a planet; and generating the second synthetic seismic data item that simulates a simplified version of the real seismic survey of the same region of the planet; and training a machine learning model on training data that includes the data item pairs, wherein the machine learning model is configured to: process an input seismic data item of a region of the planet to generate an output synthetic seismic data item that is a prediction of seismic data under a real seismic survey of the same region of the planet, or process an input seismic data item of a region of the planet to generate an output synthetic seismic data item that is a prediction of seismic data under a simplified version of the real seismic survey of the same region of the planet.

The foregoing and other embodiments of the above aspect, not defined in the appended claims, can each optionally include one or more of the following features, alone or in combination. In particular, one embodiment includes all the following features in combination. Generating the first synthetic seismic data item that simulates the real seismic survey includes generating the first synthetic seismic data item that simulates a first number of sources and receivers on the planet, wherein generating the second synthetic seismic data item that simulates the simplified version of the real seismic survey includes generating the second synthetic seismic data item that simulates a second number of sources and receivers on the planet, wherein the first number of sources and receivers is more than the second number of sources and receivers. Training the machine learning model on the training data includes: training a denoising machine learning model that is configured to remove realistic noise from the input seismic data item, wherein the input seismic data item is a real seismic data item. Training the machine learning model on the training data includes: training a style transfer neural network that is configured to generate or remove realistic noise from the input seismic data item. The actions further include receiving a real seismic data item; and processing the real seismic data item using the trained machine learning model to generate a processed real seismic data item, wherein the processed real seismic data item is similar to a synthetic seismic data item. The actions further include processing the processed real seismic data item using a seismic data analysis model, wherein the seismic data analysis model is trained on a plurality of synthetic seismic data items. The seismic data analysis model is a fault segmentation model.

Particular embodiments of the subject matter described in this specification can be implemented so as to realize one or more of the following advantages.

The systems and techniques can generate realistic synthetic seismic data items (e.g., seismic images, velocity models) of the earth using a synthetic seismic data generator by comparing a plurality of generated synthetic seismic data items and real seismic data items using an image similarity measure (e.g., in an embedding space of an autoencoder). A seismic data analysis model (e.g., a machine learning model) for seismic data analysis can be trained on the realistic synthetic seismic data items and their respective labels. Because the realistic synthetic seismic data items appear to be data items drawn from the distribution of the real seismic data items obtained in real seismic surveys, the system can reduce the domain gap between the training data (e.g., the realistic synthetic seismic data items) and the testing data (e.g., the real seismic data items) of the seismic data analysis model. Thus, the seismic data analysis model trained on the realistic synthetic seismic data items can be readily applied to real seismic images and can generate accurate seismic data analysis results. For example, a fault segmentation model (e.g., a model that uses a deep neural network for image segmentation) can be trained on realistic synthetic seismic images and their respective labels, and once trained, can perform well on a real seismic image obtained from a real seismic survey.

The systems and techniques can generate a machine learning model that can perform domain transfer from real seismic images to synthetic images, or from synthetic images to realistic synthetic images, by training the machine learning model on a plurality of pairs of synthetic images of the same region of the earth. Each pair of images includes a synthetic image with realistic noise generated using computationally intense simulation (e.g., finite difference schemes), and a synthetic image of the same region of earth with less noise and with less computation. Thus, the system can preprocess a real seismic image (e.g., reducing noise, or changing to a style of synthetic images) before inputting the real seismic image into a seismic data analysis model trained on synthetic images. The system can also generate realistic synthetic images from synthetic images and train a seismic data analysis model on the realistic synthetic images, and the trained seismic data analysis model can be readily applied to real seismic images.

The details of one or more embodiments of the subject matter of this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 is a diagram of an example system.
FIG. 2 illustrates an example of selecting realistic synthetic seismic data items.
FIG. 3 is a flow chart of an example process for selecting realistic synthetic seismic data items.
FIG. 4 is a flow chart of an example process for training a machine learning model configured to generate synthetic seismic data items.

Like reference numbers and designations in the various drawings indicate like elements.

### DETAILED DESCRIPTION

The technology in this specification is related to generating realistic synthetic seismic data items and using the realistic synthetic seismic data items for training a seismic data analysis model and using the seismic data analysis model to perform inferences on real seismic data items obtained from a seismic survey.

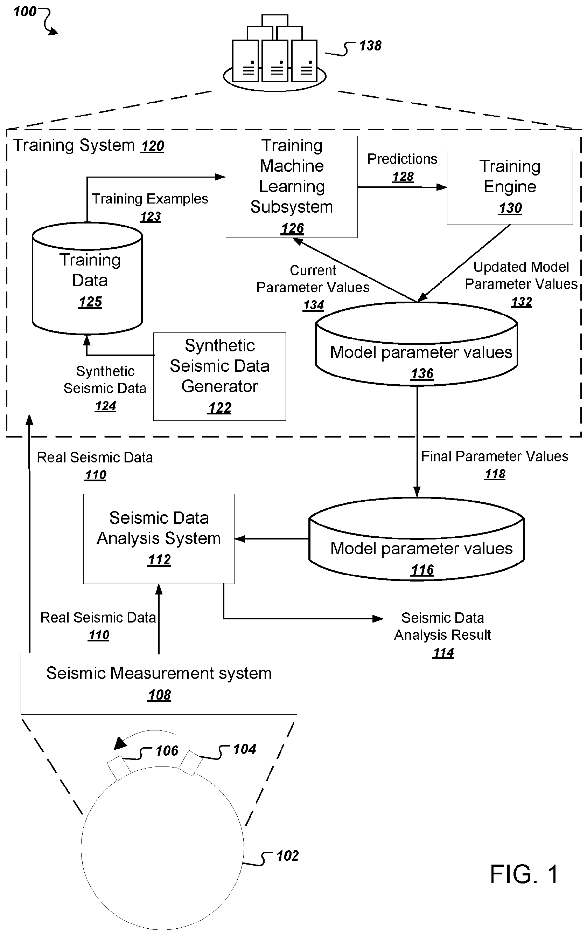

FIG. 1 is a diagram of an example system 100.

The system 100 includes a seismic measurement system 108, and a seismic data analysis system 112. The seismic measurement system 108 can be configured to perform a seismic survey of a planet (e.g., the earth 102). The seismic data analysis system 112 can be configured to perform analysis on real seismic data 110 obtained from the seismic survey and to generate seismic data analysis result 114.

The seismic measurement system 108 includes one or more energy sources (e.g., an energy source 104) and one or more receivers (e.g., a receiver 106) in an area of interest. In some implementations, the seismic measurement system 108 can include an array of energy sources and an array of receivers that can be configured to conduct a three-dimensional (3D) seismic survey. The one or more energy sources 104 can generate energy (i.e., seismic waves) that travels within the subsurface of the earth. The seismic waves are recorded at specific locations on the surface of the earth by the receivers 106. The seismic measurement system 108 generates real seismic data 110 (e.g., one or more seismic images) through analysis of vibrations from the seismic waves recorded by the receivers 106.

The real seismic data 110 includes seismic data generated in a real seismic survey and not by computer simulations. The real seismic data 110 can include one or more seismic data items. Each seismic data item can be a seismic image, e.g., a two-dimensional or three-dimensional image of a region of the subsurface of the earth. The real seismic data 110 can characterize the geological features of the planet, such as subsurface discontinuities (e.g., faults), layering, and probable rock structures.

For example, a seismic reflection survey can provide a seismic image of the subsurface of the earth generated due to density contracts between rock layers. In the seismic image, the interfaces between layers of different densities can generate continuous reflections. Faults are prominent geological features formed in the upper part of the earth's crust due to brittle deformation. The mapping of faults can be important in predicting the distribution and size of natural resources, or mitigating risks associated with geo-hazards. Faults can be recognized in a seismic image because the faults can cause discontinuities in these otherwise continuous reflections.

The real seismic data 110 can be provided to the seismic data analysis system 112. The seismic data analysis system 112 can perform seismic analysis of the planet (e.g., the earth 102) based on the received real seismic data 110, and can generate a seismic data analysis result 114. The seismic data analysis system 112 can include a seismic data analysis model that localizes or segments (e.g., delineates) one or more geological features in the real seismic data 110. The seismic data analysis result 114 can include a detection result (e.g., a bounding box) or a segmentation result (e.g., an instance segmentation mask) of the one or more geological features. For example, the seismic data analysis system 112 can include a fault segmentation model that can detect locations in the real seismic data 110 that corresponds to faults.

In some implementations, the seismic data analysis system 112 can include a machine learning model that can be trained to perform geological feature analysis. The machine learning model can receive the real seismic data 110 as input and can generate the seismic data analysis result 114. The machine learning model can include a deep neural network model that can be trained to analyze a seismic image. The deep neural network model can include one or more of a classification model, an object detection model, and a segmentation model. Examples of the deep neural network model includes: 3D U-net (Çiçek, Özgün, et al. "3D U-Net: learning dense volumetric segmentation from sparse annotation." International conference on medical image computing and computer-assisted intervention. Springer, Cham, 2016), transformers (Hatamizadeh, Ali, et al. "Unetr: Transformers for 3d medical image segmentation." Proceedings of the IEEE/CVF Winter Conference on Applications of Computer Vision. 2022), CNN-RNN model (Chen, Yani. Deep Learning based 3D Image Segmentation Methods and Applications. Ohio University, 2019), CNN-Transformer (Baker, Bowen, et al. "Video PreTraining (VPT): Learning to Act by Watching Unlabeled Online Videos." arXiv preprint arXiv:2206.11795 (2022)), and other deep learning models for 3D segmentation tasks (Wang, Andong, et al. "A novel deep learning-based 3D cell segmentation framework for future image-based disease detection." Scientific reports 12.1 (2022): 1-15).

The machine learning model can be trained on training data that includes a plurality of training examples and their respective labels. By leveraging a large amount of labeled training data, a seismic data analysis system 112 that uses a machine learning model can provide accurate seismic data analysis results. For example, a fault segmentation model (e.g., a model that uses a deep neural network for image segmentation) can be trained on seismic images and their respective labels, and once trained, can perform a fault segmentation on a real seismic image obtained from a real seismic survey.

The seismic data analysis system 112 can implement the operations of a machine learning model (e.g., operations of each layer of a neural network trained to make seismic data analysis). Thus, the seismic data analysis system 112 can include one or more computing devices having software or hardware modules that implement the respective operations of each layer of the neural network according to an architecture of the neural network.

The seismic data analysis system 112 can implement the machine learning model by loading a collection of model parameter values 116 that are received from a training system 120. Although illustrated as being logically separated, the model parameter values 116 and the software or hardware modules performing the operations may actually be located on the same computing device or, in the case of an executing software module, stored within the same memory device.

The seismic data analysis system 112 can use hardware acceleration or other special-purpose computing devices to implement the operations of the machine learning model (e.g., one or more layers of the neural network). For example, some operations of some layers may be performed by highly parallelized hardware, e.g., by a graphics processing unit or another kind of specialized computing device. In other words, not all operations of each layer need to be performed by central processing units (CPUs) of the seismic data analysis system 112.

In some implementations, the system 100 can include a training system 120 that trains the machine learning model being used in the seismic data analysis system 112. The training system 120 is typically hosted within a data center 138, which can be a distributed computing system having hundreds or thousands of computers in one or more locations.

The seismic measurement system 108 can provide real seismic data 110 to the training system 120. The training system 120 can use the real seismic data 110 as training data 125. However, because real seismic data 110 can be very noisy, it can be difficult, infeasible and time intensive to obtain a label for real seismic data 110. Also, it can be difficult or infeasible to verify whether a label of a geological feature in the real seismic data 110 is correct or not. Because obtaining real seismic data 110 can be time consuming due to the need to perform seismic surveys, it can be infeasible to obtain large amounts of real seismic data 110.

To address these issues, the system 100 (or the training system 120) can include a synthetic seismic data generator 122 that generates synthetic seismic data 124.

The synthetic seismic data generator 122 can perform a computer simulation of a seismic survey by modeling the geological features of the planet and modeling the seismic survey process. For example, a synthetic seismic data generator 122 can allow a user to specify one or more geological features, such as layers, faults, river channels, folding and erosion. The synthetic seismic data generator 122 can generate synthetic seismic data 124 (e.g., a synthetic seismic image) that simulates a real seismic data 110 obtained from a real seismic survey. In some implementations, the synthetic seismic data generator 122 can create a synthetic velocity model, run a synthetic survey, and lastly, create a synthetic seismic image from the synthetic survey. In some implementations, the synthetic seismic data generator 122 can create a synthetic velocity model and can create the synthetic seismic image directly based on the velocity model without a need to run a synthetic survey. For example, the synthetic seismic data generator 122 can generate a synthetic seismic data item as an end result without generating a realistic survey sequence. For example, the synthetic seismic data generator 122 can generate a synthetic seismic image by convolving a velocity model with a wavelet, without generating a corresponding realistic survey sequence.

It can be desirable to generate synthetic seismic data 110 that has similar appearance or similar style as the real seismic data 110. An example of existing synthetic seismic data generators include SEAM (https://seg.org/SEAM/home). However, because a real seismic surveying process can be complicated, it can be computationally complex and time consuming to generate realistic synthetic seismic images by the synthetic seismic data generator 122, especially for a three-dimensional (3D) seismic survey.

For example, the synthetic seismic data generator 122 can use a relatively complex model to generate realistic synthetic seismic data (e.g., with more noise and with curved lines) that appear to be similar to the real seismic data 110, but this simulation process can take a long period of time (e.g., days or months). Alternatively, the synthetic seismic data generator 122 can use a relatively less complex model to generate less realistic synthetic seismic data (e.g., with less noise and with straight lines) that appears less similar to the real seismic data 110. In some implementations, a synthetic seismic data generator can generate a synthetic seismic data item by applying a Laplacian to a velocity model, followed by convolving the Laplacian with a wavelet. In some implementations, a more complex synthetic seismic data generator can use a more complex simulation engine that describes the physics more comprehensively, e.g., modeling the migration data of the earth. For example, in addition to modeling the different imaging techniques, such as Kirchhoff, one-way wave equation, and finite differences, a more complex synthetic seismic data generator can model the anisotropic, elastic, and visco-elastic of the physics. The more complex synthetic seismic data generator can include more sophisticated earth property models, and can increase the complexity of the generator and the computation cost of the generator.

The synthetic seismic data generator 122 can provide a label for the synthetic seismic data based on the models of the geological features of the planet. The label for the synthetic seismic data can be an accurate label that includes geological feature information and can be easily obtained. Because the seismic data is synthetic, the generator 122 can generate labels that are guaranteed to be accurate, instead of getting noisy labels for the real seismic data. For example, a user can specify the location, size or shape of a fault as an input to the synthetic seismic data generator 122. After generating the synthetic seismic data 124 that simulates a seismic image of the fault, the synthetic seismic data generator 122 can provide a label for the seismic image of the fault, and the label can include the location, size or shape information of the fault specified by the user.

The training system 120 can include a training machine learning subsystem 126 that performs the training of a machine learning model. The training machine learning subsystem 126 can implement the operations of a machine learning model. For example, the training machine learning subsystem 126 can implement the operations of each layer of a neural network that is designed to generate a seismic data analysis result 114 from an input seismic data item (e.g., a real seismic image or a synthetic seismic image). The training machine learning subsystem 126 includes a plurality of computing devices having software or hardware modules that implement the respective operations of a machine learning model (e.g., according to an architecture of a neural network).

The training machine learning model generally has the same architecture and parameters as the machine learning model used in the seismic data analysis system 112. However, the training system 120 need not use the same hardware to compute the operations of the machine learning model. In other words, the training system 120 can use CPUs only, highly parallelized hardware, or some combination of these.

The training machine learning subsystem 126 can compute the operations of the machine learning model using current parameter values 134 of the machine learning model stored in a collection of model parameter values 136. Although illustrated as being logically separated, the model parameter values 136 and the software or hardware modules performing the operations may actually be located on the same computing device or on the same memory device.

The training machine learning subsystem 126 can receive training examples 123 as input. The training examples 123 can include labeled training data 125. Each of the training examples 123 includes a synthetic seismic data item (e.g., a seismic image in 2D or 3D) as well as one or more labels that indicate one or more geological features in the synthetic seismic data item. For example, a training example 123 can include a seismic image and a segmentation mask for a fault in the seismic image.

The training machine learning subsystem 126 can generate, for each training example 123, a prediction 128 using a seismic data analysis machine learning model that is being trained by the training machine learning subsystem 126. The prediction 128 can include a seismic data analysis result for one or more geological features of a region of a planet, such as subsurface discontinuities (e.g., faults), layering, and probable rock structures. For example, the prediction 128 can include a bounding box or a segmentation mask of a geological feature (e.g., a fault) detected in the seismic image, a likelihood score indicating the likelihood that a geological feature exists in the seismic image, or a combination of the above.

A training engine 130 analyzes the predictions 128 and compares the predictions 128 to the labels in the training examples 123 using a loss function, e.g., a mean-squared error loss, a cross entropy loss, etc. The training engine 130 then generates, based on the value of the loss function, updated model parameter values 132 by using an appropriate updating technique, e.g., stochastic gradient descent with backpropagation. Then training engine 130 can then update the collection of model parameter values 136 using the updated model parameter values 132.

After training is complete, the training system 120 can provide a final set of model parameter values 118 to the machine learning model included in the seismic data analysis system 112 for use in generating seismic data analysis results 114. The training system 120 can provide the final set of model parameter values 118 by a wired or wireless connection to the seismic data analysis system 112.

In some implementations, the system 100 can be configured to generate realistic synthetic seismic data items of the earth. The system can compare a plurality of synthetic seismic data items, e.g., the synthetic seismic data 124, and a plurality of real seismic data items, e.g., the real seismic data 110, using an image similarity measure.

For example, the system can compare the synthetic seismic data items and the real seismic data items in an embedding space of an autoencoder. The system can process each of the plurality of synthetic seismic data items using an encoder and the system can process each of the plurality of real seismic data items using the same encoder. The autoencoder can include the encoder that processes an input seismic data item to generate an embedding, and a decoder that processes the embedding to regenerate the input seismic data item.

The system can determine a range for one or more parameters of the synthetic seismic data generator 122 and the synthetic seismic data items generated with a respective combination of values for the one or more parameters that are within the determined range can be the realistic synthetic seismic data items.

A seismic data analysis model (e.g., a machine learning model) of the seismic data analysis system 112 can be trained on the realistic synthetic seismic data items and their respective labels. Because the realistic synthetic seismic data items appear to be data items drawn from the distribution of the real seismic data items obtained in real seismic surveys, the system can reduce the domain gap between the training data (e.g., the realistic synthetic seismic data items) and the testing data (e.g., the real seismic data 110) of the seismic data analysis model. Thus, the seismic data analysis model trained on the realistic synthetic seismic data items can be readily applied to real seismic images and can generate accurate seismic data analysis results.

In some implementations, the system 100 can generate a machine learning model that can perform domain transfer from real seismic data 110 to synthetic seismic data 124, or from synthetic seismic data 124 to realistic synthetic data items. The system can train the machine learning model on a plurality of pairs of synthetic images of the same region of the earth. Each pair of images includes a synthetic image with realistic noise generated using computationally intense simulation (e.g., finite difference schemes), and a synthetic image of the same region of earth with less noise and with less computation.

The system can use the trained machine learning model to preprocess real seismic data 110 (e.g., reducing noise, or changing to a style of synthetic images) before inputting the real seismic data 110 into the seismic data analysis system 112 trained on synthetic seismic data 124. The system can also generate realistic synthetic data items from synthetic seismic data 124 and train the seismic data analysis system 112 on the realistic synthetic items, such that the trained seismic data analysis system 112 can be readily applied to real seismic data 110.

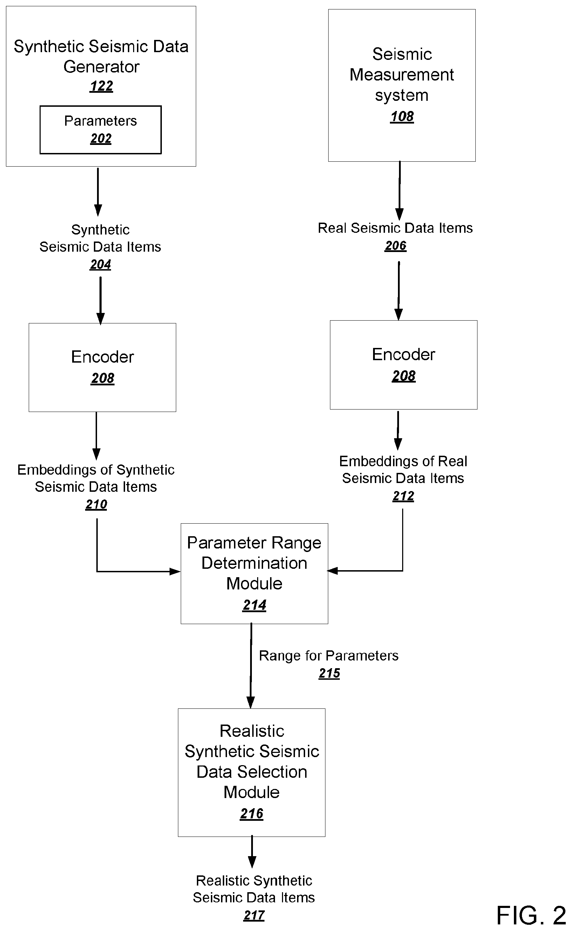

FIG. 2 illustrates an example of selecting realistic synthetic seismic data items. The example illustrates a technique that determines the range for the values for one or more parameters of a synthetic seismic data generator by comparing synthetic seismic data items and real seismic data items in an image similarity measure. The process will be described as being performed by an appropriately programmed computer system, e.g., the system 100 of FIG. 1.

The system includes a synthetic seismic data generator 122 that can be configured to generate a plurality of synthetic seismic data items 204. The synthetic seismic data generator 122 includes one or more parameters 202. The parameters 202 can include properties of the earth, e.g., number of depositions, number of layers, number of faults, and parameters of the faults. The parameters 202 can be adjusted to configure the computer simulation of a seismic survey (e.g., imaging) process, e.g., convolution with wavelet, physics simulation, etc. The parameters 202 can be adjusted to result in different image quality (e.g., noise level) and image appearance of the resulting synthetic seismic images. The parameters 202 can be parameters for the models of the earth properties, such as geological properties in different basins of the earth (e.g., isotropy or anisotropy of the earth, number of faults, and angle for each fault), different earth environments (e.g., velocities of geological movements), etc. For example, the parameters 202 can include the length, azimuth, and shape of a fault, the rugosity of a river channel, the interbed interval and variability of a depositional layer, depositional spatial variability, wavelet frequency, etc. In some implementations, the parameters 202 can include hundreds or thousands of parameters that collectively determine the earth model, the image quality, and image appearance of the synthetic seismic data items 204.

The system can obtain a plurality of synthetic seismic data items 204 (e.g., synthetic seismic images) generated by the synthetic seismic data generator 122. Each synthetic seismic data item has been generated with a respective combination of values for one or more parameters of the synthetic seismic data generator 122. For example, the synthetic seismic data generator can include a first parameter that can have a value ranging between 0 and 10 and a second parameter that can have a value ranging between 1 and 100. Each synthetic seismic data item can be generated with a respective combination of a first value for the first parameter sampled from the range between 0 and 10 and a second value for the second parameter sampled from the range between 1 and 100.

The system can use one or more image similarity measures to assess how realistic the synthetic seismic data items 204 are and can determine a range for the parameters 202 of the synthetic seismic data generator 122 to select more realistic synthetic seismic data items. Examples of image similarity measures include deep neural network methods (e.g., an embedding space determined by a trained autoencoder, a trained convolutional neural network with Triplet Loss), image descriptors (e.g., SIFT, SURF, HoG, etc.), and other metrics such as Mean Squared Error (MSE), Peak Signal-to-Noise Ratio (PSNR), Structural Similarity Index (SSIM).

The system can include an encoder 208 that can be configured to process each of the plurality of synthetic data items 204. The encoder 208 can be an encoder included in a trained autoencoder. Generally, an autoencoder is a type of neural network for unsupervised learning and the autoencoder includes an encoder and a decoder. Autoencoders operate by taking in data, compressing and encoding the data by the encoder, and then reconstructing the data from the encoded representation or an embedding using the decoder. An autoencoder can provide an image similarity measure in the embedding space of the autoencoder.

In our implementations, the autoencoder can include the encoder 208 that processes an input seismic data item to generate an embedding, and a decoder that processes the embedding to regenerate the input seismic data item. The autoencoder can be trained using a plurality of synthetic seismic data items and a plurality of real seismic data items. During training, the encoder generates an embedding from an input seismic data item and the decoder generates a reproduced seismic data item from the embedding. Parameters of the autoencoder can be updated until the reproduced seismic data item is as close as possible to the input seismic data item, e.g., to minimize a reconstruction error between input seismic data items and the corresponding reproduced seismic data items generated by the decoder. After training is completed, the encoder 208 of the autoencoder can be used to generate an embedding of an input seismic data item.

The encoder 208 can include any type of neural network model that can be configured to generate features of an input seismic data item. For example, the encoder 208 can be a convolution neural network that includes a plurality of convolutional layers and can be configured to process an input seismic image..

The system can process each synthetic seismic data item 204 using the encoder 208 to generate an embedding 210 of the respective synthetic seismic data item. An embedding, as used in this specification, is a numeric representation of a synthetic seismic data item and can characterize features of the synthetic seismic data item. In particular, an embedding is a numeric representation in an embedding space, i.e., an ordered collection of a fixed number of numeric values, where the number of numeric values is equal to the dimensionality of the embedding space. For example, the embedding can be a vector of floating point or other types of numeric values. Generally, the dimensionality of the embedding space is much smaller than the number of numeric values in the synthetic seismic data represented by a given embedding. The embeddings 210 of the synthetic seismic data items can represent the features of each respective synthetic seismic data item in an embedding space of the encoder 208.

The system can include a seismic measurement system 108 that generates real seismic data items 206. The system can use the same encoder 208 that processes the synthetic seismic data items 204 to process the real seismic data items 206. The system can process each real seismic data item 206 using the encoder 208 to generate an embedding 212 of the respective real seismic data item. The embeddings 212 of the real seismic data items can represent the features of each respective real seismic data item in the embedding space of the encoder 208.Thus, the embeddings 212 of the real seismic data items and the embeddings 210 of the synthetic seismic data items are in the same embedding space of the encoder 208.

The system can compare the real seismic data items 206 and the synthetic seismic data items 204 in an image similarity measure (e.g., in the embedding space of the autoencoder) such that the system can find a way to select some synthetic data items that are similar to the real seismic data items. For example, the system can select, from a "warehouse" of previously generated synthetic seismic data items, the synthetic data items that are similar to the real seismic data items. The "warehouse" of the previously generated synthetic seismic data items may or may not include the synthetic seismic data items 204. As another example, the system can generate new synthetic data items that are similar to the real seismic data items. The selected or generated synthetic data items that are similar to the real seismic data items can be included in a training set, and a seismic data analysis model can be trained on the training set.

In general, a user can provide to the system real seismic data items obtained from a seismic survey of a real world region of interest. The system can be configured to generate realistic synthetic seismic data items that are similar to the real seismic data items, and the realistic synthetic seismic data items can have accurate labels.

The system can include a parameter range determination module 214. The parameter range determination module 214 can determine the range 215 for the values for the one or more parameters 202 of the synthetic seismic data generator 122.

In some implementations, the system can determine the range 215 for the value for the one or more parameters 202 by comparing the synthetic seismic data items 204 and the real seismic data items 206 in the embedding space of the encoder 208. That is, the system can compare the embeddings 210 of the synthetic seismic data items 210 and the embeddings 212 of the real seismic data items, and determine the range for the parameters 202 such that the synthetic seismic data items have similar embeddings or image features as the real data items generated from real seismic surveys.

In some implementations, the system can determine the range 215 for the value for the one or more parameters 202 by collecting information from a seismic image. For example, the system can process an existing seismic image, e.g., a realistic seismic image, through horizontal, fault, and channel detection, to obtain meta-data of the existing seismic image. The system can use the meta-data to constrain the synthetic seismic data generator 122. In some implementations, a human can manually collect the meta-data from the existing seismic image.

In some implementations, the system can determine the range 215 for the value for the one or more parameters 202 by comparing the synthetic seismic data items 204 and the real seismic data items 206 in the embedding space of the encoder 208 and by collecting information from a seismic image and use the information to constrain the synthetic seismic data generator 122.

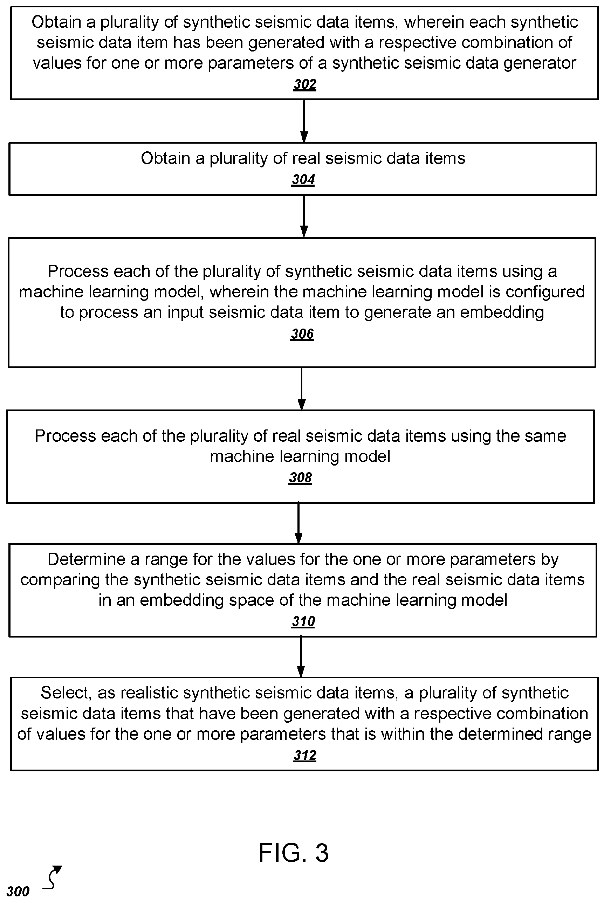

In some implementations, the parameter range determination module 214 can be a learned machine learning model, a blackbox optimizer, or other types of optimizer. More details regarding parameter range determination using an optimizer is described below in connection with FIG. 3.

Utilizing the ranges for the parameters, the system can obtain realistic synthetic seismic data items that are close to the real seismic data items (e.g., seismic images) generated from the real seismic surveys in the embedding space of the encoder 208. Therefore, the system can reduce the domain gap between the training data (e.g., the synthetic seismic data items) and the testing data (e.g., the real seismic data items) of a seismic data analysis model used by the seismic data analysis system 112 in FIG. 1.

The system can include a realistic synthetic seismic data selection module 216. The system can select, as realistic synthetic seismic data items 217, a plurality of synthetic seismic data items that have been generated with a respective combination of values for the one or more parameters that is within the determined range 215. The realistic synthetic seismic data item 217 can have similar appearance or image features as real seismic images. For example, the realistic synthetic seismic data items 217 (e.g., realistic seismic images) can have non-straight lines and similar noise patterns as in the real seismic data items (e.g., real seismic images) obtained from real seismic surveys.

For example, if the system determines that the range for the first parameter of the synthetic seismic data generator is between 2 and 4, and the range for the second parameter of the synthetic seismic data generator is between 40 and 55, the system can select, from a plurality of synthetic seismic data items that are already generated, a plurality of synthetic seismic data items that have been generated with a combination of a first parameter value between 2 and 4 and a second parameter value between 40 and 55. The selected plurality of synthetic seismic data items can be the realistic synthetic data items 217 that appear similar to the real seismic data items. An another example, the system can generate new synthetic seismic data items with a combination of a first parameter value between 2 and 4 and a second parameter value between 40 and 55, and the newly generated synthetic seismic data items can be the realistic synthetic data items 217 that appears similar to the real seismic data items.

In some implementations, the system can use a similar process to select a subset of synthetic seismic data items from a synthetic library that includes a plurality of synthetic seismic data items to match real seismic data items. The subset of the synthetic seismic data items can be used as a training set to train and tune a machine learning model for seismic analysis of a target area.

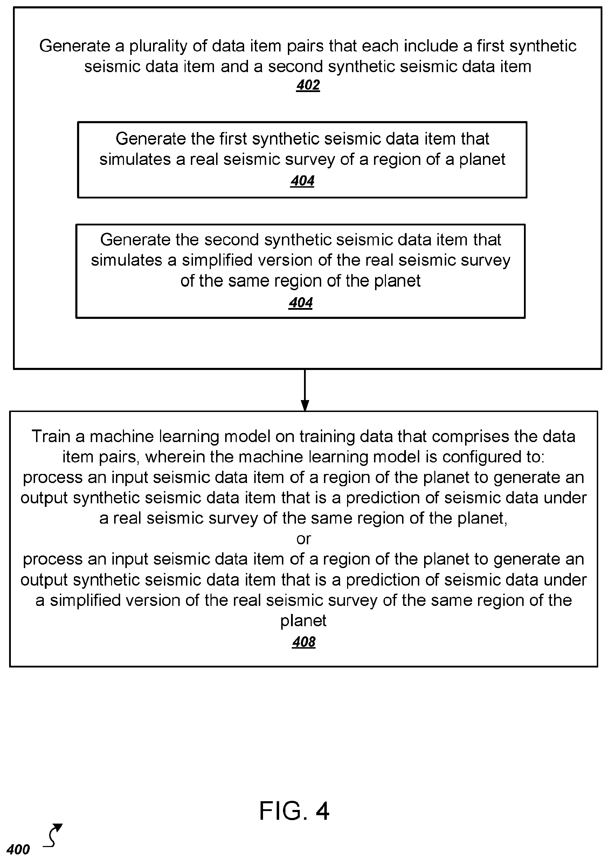

In some implementations, prior to being processed by the encoder 208, the system can process the synthetic seismic data items 204 or the real seismic data items 206, or both of them, using a machine learning model or other types of signal processing method to change the appearance of an input seismic data item. The training of the machine learning model that can change the appearance of the input seismic data item is described below in connection with FIG. 4.

For example, the system can process a real seismic data item of a region of the planet using the machine learning model to generate an output synthetic seismic data item that is a prediction of seismic data under a simplified version of a real seismic survey of the same region. The system can generate an embedding of the output synthetic seismic data item and compare it with the embeddings of the synthetic seismic data items 210. Because the output synthetic seismic data item is a prediction of seismic data under a simplified version of the real seismic survey, the system can more efficiently and more accurately determine the range for the parameters of the synthetic seismic data generator 122.

As another example, the system can process a synthetic seismic data item of a region of the planet using the machine learning model to generate an output synthetic seismic data item that is a prediction of seismic data under a real seismic survey of the same region. The system can generate an embedding of the output synthetic seismic data item and compare the embedding with the embeddings of the real seismic data items 212. Because the output synthetic seismic data item is a prediction of seismic data obtained under a real seismic survey, the system can more efficiently and more accurately determine the range for the parameters of the synthetic seismic data generator 122.

FIG. 3 is a flow chart of an example process 300 for selecting realistic synthetic seismic data items. The process will be described as being performed by a system of one or more computers in one or more locations, appropriately programmed in accordance with this specification. For example, the system can be implemented in a machine learning training system, e.g., the training system 120 of FIG. 1, a seismic data analysis system, e.g., the seismic data analysis system 112 of FIG. 1, or a synthetic seismic data generator, e.g., the synthetic seismic data generator 122 of FIG. 1, or a combination of above.

The system obtains a plurality of synthetic seismic data items (302). Each synthetic seismic data item has been generated with a respective combination of values for one or more parameters of a synthetic seismic data generator. For example, each synthetic seismic data item can be a synthetic seismic image generated by a computer simulation program that is implemented in the synthetic seismic data generator.

The system obtains a plurality of real seismic data items (304). For example, each real seismic data item can include a seismic image of the earth obtained in a real seismic survey.

The system processes each of the plurality of synthetic seismic data items using a machine learning model (306). The machine learning model can be configured to process an input seismic data item to generate an embedding. The system can generate an embedding of each synthetic seismic data item by processing each synthetic seismic data item using the machine learning model.

In some implementations, the machine learning model can be an encoder of an autoencoder, wherein the autoencoder includes the encoder that processes the input seismic data item to generate the embedding, and a decoder that processes the embedding to regenerate the input seismic data item. In some implementations, the system can train the machine learning model using the plurality of the synthetic seismic data items and the plurality of real seismic data items. For example, during training, the system can update the parameters of the autoencoder (e.g., including the parameters of the encoder and the parameters of the decoder) such that the regenerated seismic data item is as close as possible to an input seismic data item which can be a synthetic or real seismic data item.

In some implementations, the machine learning model can be a classification machine learning model trained to perform a classification task on seismic data items. The system can generate an embedding of a seismic data item using the trained classification machine learning model. In some implementations, the machine learning model can be a generative adversarial network (GAN) model trained to perform an in-painting task on seismic data items. For example, the GAN model can be trained to fill in missing subvolumes in a seismic data item based on subvolumes around it. The system can generate an embedding of a seismic data item using the trained GAN model.

The system processes each of the plurality of real seismic data items using the same machine learning model (308). For example, the system can generate an embedding of each real seismic data item by processing each real seismic data item using the same encoder that the system uses to process the synthetic seismic data items. Therefore, the embeddings of the synthetic seismic data items and the embeddings of the real seismic data items are in the same embedding space of the autoencoder, and are ready for comparison.

The system determines a range for the values for the one or more parameters by comparing the synthetic seismic data items and the real seismic data items in the embedding space of the machine learning model (310).

For example, the system can perform a cluster analysis, or clustering, over the embeddings of the synthetic seismic data items to determine a plurality of clusters of the embeddings of the synthetic seismic data items. The system can also perform clustering over the embeddings of the real seismic data items to determine one or a few clusters of the embeddings of the real seismic data items. The system can select one or more clusters of the embeddings of the synthetic seismic data items that are close to a cluster of the real seismic data items, e.g., if the distance of the centers of the two clusters are less than a threshold. The system can determine the range for the values for the one or more parameters of the synthetic seismic data generator using the values for the one or more parameters that have been used to generate the synthetic seismic data items corresponding to the selected one or more clusters.

For example, the system can obtain embeddings of a plurality of real seismic data items. For each real seismic data item, the system can obtain a cluster of synthetic data items and each synthetic data item has an embedding with a distance from the embedding of the real seismic data item that is smaller than a threshold. The system can determine the range for the values of the one or more parameters of the synthetic seismic data generator using the parameters of the synthetic data items in the cluster.

In some implementations, the system can determine the range for the values for the one or more parameters using a blackbox optimizer (e.g., grid search, random search, or a model-based blackbox optimization algorithm). For example, the system can determine a set of synthetic seismic data items that are closest to the real seismic data items in the embedding space. The system can determine a first range based on the determined set of synthetic seismic data items. The system can generate a second range based on the first range such that the synthetics generated using the second range for the parameters are closer to the reals in the embedding space. As another example, the parameters can be the number of faults and possible angles for each fault. The system can perform a grid search by specifying possible numbers of faults (e.g., 1, 2, 3, and 4) and their respective angles (e.g., 75 degrees, 80 degrees, and 85 degrees). The system can generate a plurality of synthetic seismic data items using a combination of the values for the parameters. The system can determine a range for the parameters that correspond to synthetics that are close to the reals in the embedding space.

In some implementations, the system can determine the range such that a distance between an embedding of a synthetic seismic data item generated with a respective combination of values for the one or more parameters that is within the range and an embedding of a real seismic data item is smaller than a threshold. For example, for each real seismic data item, the system can determine the range of the parameters that corresponds to embeddings of the synthetic seismic data items that are within a threshold distance from the embedding of the real seismic data item. The system can aggregate the ranges and can determine a final range for the parameters (e.g., a union of the ranges or an intersection of the ranges).

In some implementations, the system can use a loss function to measure a distance between the real seismic data items and the synthetic seismic data items in the embedding space of the autoencoder. The system can generate updated values of the parameters by minimizing the value of the loss function, and the updated values of the parameters can be used to determine the range for the values for the parameters. For example, the system can generate the updated values of the parameters by using an appropriate updating technique, e.g., stochastic gradient descent with backpropagation through the encoder.

In some implementations, the system can determine the range for the parameters based on one or more earth properties of the plurality of real seismic data items. The one or more earth properties can include fault density range, rock property estimations, etc. For example, inversion techniques in geophysics can generate impedance information, which can be used to predict rock information, velocity information, etc. Based on the one or more earth properties determined from the real seismic data items obtained from real seismic surveys, the system can determine realistic or possible range for one or more parameters used in the synthetic seismic data generator. In some implementations, the system can determine the range based on both the one or more earth properties of the plurality of real seismic data items and based on comparing the synthetic seismic data items and the real seismic data items in an embedding space of the autoencoder.

The system selects, as realistic synthetic seismic data items, a plurality of synthetic seismic data items that have been generated with a respective combination of values for the one or more parameters that is within the determined range (312). In some implementations, the system can select the plurality of synthetic seismic data items using a reinforcement learning model. In some implementations, the system can select the plurality of synthetic seismic data items using other types of optimization methods. For example, the system can use a reinforcement learning model to make a synthetic seismic dataset look more similar to a real seismic dataset, or vice versa. The reinforcement learning model can have access to a list of augmentations (e.g., signal processing operations) and the system can use the reinforcement learning model to select an optimal set of operations and their ordering to make a synthetic seismic dataset look more similar to a real seismic dataset, or vice versa.

In some implementations, the system can select, as the realistic synthetic seismic data items, from the obtained plurality of synthetic seismic data items, the plurality of synthetic seismic data items that have been generated with the respective combination of values for the one or more parameters that is within the determined range. For example, referring to FIG. 2, the system can select the realistic synthetic seismic data items 217 from the obtained plurality of synthetic seismic data items 204, and the selected realistic synthetic seismic data items 217 have been generated with the respective combination of values for the one or more parameters that is within the determined range 215. That is, the system can select the realistic synthetic seismic data items 217 from existing synthetic seismic data items 204 that have already been generated, without a need to generate new synthetic data items.

In some implementations, the system can generate, as the realistic synthetic seismic data items, new synthetic seismic data items using the synthetic seismic data generator by setting the respective combination of values for the one or more parameters within the determined range. For example, referring to FIG. 2, the system can use the synthetic seismic data generator 122 to generate a new set of synthetic seismic data items by setting the respective combination of values for the one or more parameters within the determined range 215. The newly generated synthetic seismic data items can have the desired image features or appearance as the real seismic data items. The newly generated synthetic seismic data items can be the realistic synthetic seismic data items 217.

In some implementations, the realistic synthetic seismic data items can include both new synthetic seismic data items generated using the synthetic seismic data generator by setting the respective combination of values for the one or more parameters within the determined range, and a plurality of synthetic seismic data items that are selected from previously generated synthetic seismic data items and that have been generated with the respective combination of values for the one or more parameters that is within the determined range.

In some implementations, the system can train a seismic data analysis model on the realistic synthetic seismic data items generated by the synthetic seismic data generator. The realistic synthetic seismic data items can be associated with respective labels. Although the real seismic data items may not be associated with labels, the realistic synthetic seismic data items generated based on the real seismic data items using techniques described in the steps (302)-(312) can have accurate labels and the realistic synthetic seismic data items can have similar appearance as the real seismic data items. Because realistic synthetic seismic data items are generated by the synthetic seismic data generator, the system can obtain the respective labels for the realistic synthetic seismic data items. For example, the synthetic seismic data generator can provide a label for the synthetic seismic data based on the synthetic model. The label for the synthetic seismic data item can be an accurate label that includes geological feature information of a region of the earth and can be obtained from the synthetic seismic data generator. In some implementations, the system can obtain the labels from the model parameters of the synthetic seismic data generators and the generated synthetic data items. For example, the system can process the synthetic seismic images, the meta-data of the synthetic seismic images, or both. Because the realistic synthetic seismic data items are selected to have similar image features or appearance as real seismic data items, the seismic data analysis model trained on the realistic seismic data item can be applied on real seismic data items and can produce accurate seismic data analysis results.

The seismic data analysis model can be used by a seismic data analysis system (e.g., the seismic data analysis system 112 in FIG. 1) to perform seismic analysis of a planet (e.g., the earth) on seismic data items (e.g., seismic images). For example, the seismic data analysis model can be trained to localize or segment (e.g., delineates) one or more geological features in a seismic image.

In some implementations, the system can perform a supervised training method or process to train the seismic data analysis model (e.g., a machine learning model such as a neural network model). The system can train the machine learning model on the realistic synthetic seismic data items selected with the determined range for the parameters of the synthetic seismic data generator, and the respective labels for the realistic synthetic seismic data items.

In some implementations, the seismic data analysis model can analyze one or more earth properties, including: faults, channels, facies, and horizons, etc. For example, the seismic data analysis model can be a fault analysis model that identifies one or more parameters of a fault, e.g., fault type, fault angle, fault slip. In some examples, the seismic data analysis model can be a fault segmentation model that can be trained to generate a segmentation mask of a detected fault. The system can train the seismic data analysis model (e.g., a deep neural network model that is configured to perform image segmentation) on the realistic synthetic seismic data items and their respective labels. The labels can include a ground truth earth property, e.g., a segmentation mask for each fault in the seismic data item (e.g., each seismic image), and can be provided by the synthetic seismic data generator. Once trained, the system can use the seismic data analysis model to analyze the one or more earth properties on real seismic data items obtained in real seismic surveys.

In some implementations, the system can train the seismic data analysis model on: (i) the realistic synthetic seismic data items and the respective labels; and (ii) a plurality of real seismic data items, and the plurality of real seismic data items do not have labels. The system can perform a semi-supervised training method or process to train the seismic data analysis model. For example, the system can train the seismic data analysis model using clustering. The system could cluster the labeled realistic synthetic seismic data items and the unlabeled real seismic data items. Within a cluster, if a seismic data item is labeled as having a particular earth property, the system can determine that other seismic data items in the cluster are likely having the same earth property. The system can use this technique to identify rock facies, e.g., identifying a particular facies type, such as sandstone. The system can use this technique to identify locations of river channels, chimneys, basalts, etc.

In some implementations, before processing each of the plurality of real seismic data items using the machine learning model, the system can process the plurality of real seismic data items such that the plurality of real seismic data items appear to be data items drawn from a distribution of synthetic seismic data items. The system can perform an image preprocessing process on the real seismic data items such that the statistical distribution of the real seismic data items are similar to the statistical distribution of the synthetic seismic data items. The system can compare the synthetic seismic data items and the preprocessed real seismic data items in the embedding space of the autoencoder. Thus, the system can more easily find synthetic seismic data items that are close to the preprocessed real seismic data items in the embedding space.

In some implementations, the system can perform image processing or computer vision algorithms on the real seismic data items such that the plurality of real seismic data items appear to be data items drawn from a distribution of synthetic seismic data items. For example, the system can perform a signal or image processing process, e.g., normalization or whitening, on the real seismic data items, e.g., to remove noise. In some implementations, the system can determine one or more parameters of the signal or image processing based on the embedding space similarity between the real seismic data items and the synthetic seismic data item. As another example, the system can apply an operator to straighten the lines in the real seismic data items because synthetic seismic data items usually have straighter lines than the real seismic data items. As another example, amplitude variations can be more complex in the real seismic data items than the synthetics, and the system can perform a signal processing operation to reduce the amplitude variations in the real seismic data items. As another example, the system can minimize or eliminate migration artifacts in the real seismic data items.

In some implementations, the system can perform the processing on the real seismic data items using a neural network that can be trained to make a real seismic data item (e.g., a real seismic image) look like a synthetic seismic data item (e.g., a synthetic seismic image). For example, the system can process the real seismic data items using a style transfer neural network (Gatys, Leon A., Alexander S. Ecker, and Matthias Bethge. "A neural algorithm of artistic style." arXiv preprint αrXiv:1508.06576 (2015*)*) that can be trained to generate a preprocessed real seismic data item having the style of a synthetic seismic data item.

When performing seismic analysis of a real seismic data item using a seismic data analysis model trained on the synthetic seismic data items, before providing the real seismic data item to the trained seismic data analysis model, the system can perform a corresponding preprocessing to the real seismic data item such that the real seismic data item appear to be a data item drawn from a distribution of synthetic seismic data items, and the corresponding preprocessing can be the same processing applied to the real seismic data items before processing each of the plurality of real seismic data items using the encoder for comparison in the embedding space.

In some implementations, before processing each of the plurality of synthetic seismic data items using the machine learning model, the system can process the plurality of synthetic seismic data items such that the plurality of synthetic seismic data items appear to be data items drawn from a distribution of real seismic data items. The system can perform an image preprocessing process on the synthetic seismic data items such that the preprocessed synthetic seismic data items have similar appearance as the real seismic data items. Therefore, when comparing the preprocessed synthetic seismic data items and the real seismic data items in the embedding space, the system can more easily find some of the preprocessed synthetic seismic data items that are close to the real seismic data items in the embedding space.

In some implementations, the system can preprocess the synthetic seismic data items using geophysics simulations. For example, the system can migrate the synthetic seismic data items by using realistic apposition parameters. The system can model the seismic data acquisition process using realistic apposition parameters and can migrate the synthetic seismic data items by using realistic apposition parameters. Although some acquisition parameters may not be perfect, the system can generate realistic noise related to the acquisition geometries. In some implementations, the system can perform image processing or computer vision algorithms on the synthetic seismic data items. For example, the system can add noise, change the noise pattern, or add artifacts such that the preprocessed synthetic seismic data items appear similar to the real seismic data items. In some implementations, the system can perform the processing on the synthetic seismic data items using a neural network that can be trained to make a synthetic seismic data item (e.g., a synthetic seismic image) look like a real seismic data item (e.g., a real seismic image). For example, the system can process the synthetic seismic data items using a style transfer neural network that can be trained to generate a synthetic seismic data item having the style of a real seismic data item.

When training a seismic data analysis model on the synthetic seismic data items, before providing the synthetic seismic data items to the training system as training examples, the system can perform a corresponding preprocessing to each synthetic seismic data item such that the synthetic seismic data items appear to be data items drawn from a distribution of real seismic data items. The corresponding preprocessing can be the same preprocessing applied to the synthetic seismic data items before processing each of the plurality of synthetic seismic data items using the encoder for comparison in the embedding space.

FIG. 4 is a flow chart of an example process 400 for training a machine learning model configured to generate synthetic seismic data items. The process will be described as being performed by a system of one or more computers in one or more locations, appropriately programmed in accordance with this specification. For example, the system can be implemented in a machine learning training system, e.g., the training system 120 of FIG. 1.

The system generates a plurality of data item pairs that each includes a first synthetic seismic data item and a second synthetic seismic data item (402). For each data item pair, the system generates the first synthetic seismic data item that simulates a real seismic survey of a region of a planet and the second synthetic seismic data item that simulates a simplified version of the real seismic survey of the same region of the planet. Here, the planet can be the earth, or other celestial body, such as the moon, or any planet in the solar system.

For example, the first synthetic seismic data item can be generated by simulating a real seismic survey, e.g., by finite difference wave equations that have similar data acquisition parameters of a real seismic survey and having receivers at locations that are commonly associated with real life acquisition techniques. Thus, the first synthetic seismic data item can have realistic noise as in a real seismic data item collected from a real seismic survey. The second synthetic seismic data item does not have realistic noise. The second synthetic seismic data item can be generated by simulating a simplified version of the real seismic survey. Generating the second synthetic seismic data item by simulating the simplified version of the real seismic survey can take less computation than generating the first synthetic data item.

In some implementations, it is desirable that the seismic measurement system 108 includes fewer receivers, fewer sources, or both, and produces seismic survey data with a quality similar to the seismic survey data obtained from a system with more receivers, more sources, or both. Thus, in some implementations, the system can generate the first synthetic seismic data item that simulates a first number of sources and receivers and can generate the second synthetic seismic data item that simulates a second number of sources and receivers, and the first number of sources and receivers can be more than the second number of sources and receivers. Using the first synthetic seismic data and the second seismic data, the system can generate seismic survey data that simulates surveys obtained with more sources/receivers.

For example, referring to FIG. 1, the system can generate the first synthetic seismic data item that simulates hundreds of energy sources and hundreds of receivers, similar to the number of energy sources 104 and receivers 106 used in a real seismic survey performed by a seismic measurement system 108. However, this simulation can require lots of computation resources and may take a long time. Thus, the first synthetic seismic data item can have a similar appearance as a real seismic data item, e.g., real seismic data 110, in terms of signal strength, noise pattern, etc. The system can generate the second synthetic seismic data item that simulates only several energy sources and several receivers, e.g., one energy sources and three receivers, similar to the number of energy sources and receivers used by the synthetic seismic data generator 122 in a simulation that aims at generating a large amount of training data to train a seismic data analysis model. Thus, the simulation for generating the second synthetic seismic data item can require less computation resources than generating the first synthetic seismic data item.

The system trains a machine learning model on training data that includes the data item pairs (408), and the machine learning model is configured to process an input seismic data item of a region of the planet to generate an output synthetic seismic data item that is a prediction of seismic data under a real seismic survey of the same region of the planet, or process an input seismic data item of a region of the planet to generate an output synthetic seismic data item that is a prediction of seismic data under a simplified version of the real seismic survey of the same region of the planet. In some implementations, the system can train two machine learning models including: a first machine learning model configured to process an input seismic data item of a region of the planet to generate an output synthetic seismic data item that is a prediction of seismic data under a real seismic survey of the same region of the planet, and a second machine learning model configured to process an input seismic data item of a region of the planet to generate an output synthetic seismic data item that is a prediction of seismic data under a simplified version of the real seismic survey of the same region of the planet. Thus, the system can train a machine learning model to generate a realistic synthetic seismic data item (e.g., with desired noise or artifacts) from a synthetic seismic data item that simulates a simplified version of the real seismic survey. Alternatively, the system can train another machine learning model to perform preprocessing on a real seismic data item, such as denoising, and after the preprocessing, the processed real seismic data item can have a similar appearance as a synthetic seismic data item that simulates a simplified version of the real seismic survey.

In some implementations, the system can train a denoising machine learning model that can be configured to remove realistic noise from the input seismic data item, and the input seismic data item can be a real seismic data item. In some implementations, the denoising machine learning model can be a denoising autoencoder, or other types of machine learning model. In some implementations, the denoising machine learning model can be trained using a loss function (e.g., a mean-squared error loss) that measures a difference between a predicted denoised seismic data item and a target synthetic seismic data item that has low noise. The denoising machine learning model can be trained to remove noise from a real seismic data item, and can generate a processed real seismic data item that has a similar noise pattern and/or a similar noise level as a synthetic seismic data item.

In some implementations, the system can train a style transfer neural network that can be configured to generate or remove realistic noise from the input seismic data item. In some implementations, the style transfer neural network architecture (e.g., Gatys, Leon A., Alexander S. Ecker, and Matthias Bethge. "A neural algorithm of artistic style." arXiv preprint arXiv:1508.06576 (2015*)*) can extract style representations and content representations from multiple intermediate layers and can include a loss function that is a sum of a style loss and a content loss. For example, the system can train a style transfer neural network that can take a real seismic image as input and can generate a seismic image that has similar style features (e.g., straighter lines, less noise) as a synthetic seismic image, while keeping the same content features (e.g., same fault location). As another example, the system can train another style transfer neural network that can take a synthetic seismic image as input and can generate another seismic image that has similar style features (e.g., curved lines, more noise) as a real seismic image, while keeping the same content features (e.g., same fault location).

In some implementations, the system can receive a real seismic data item, and can process the real seismic data item using the trained machine learning model to generate a processed real seismic data item, and the processed real seismic data item can be similar to a synthetic seismic data item. That is, the system can perform preprocessing on the real seismic data item using the trained machine learning model. After preprocessing, the processed real seismic data item can have a similar appearance as a synthetic seismic data item.

In some implementations, the system can process the processed real seismic data item using a seismic data analysis model, and the seismic data analysis model can be trained on a plurality of synthetic seismic data items. In some implementations, the seismic data analysis model can be a fault segmentation model. Because the seismic data analysis model is trained on the synthetic seismic data items, the model can have better performance processing input data that has similar appearance as the synthetic seismic data items. By generating processed real seismic images that have similar appearance as the synthetic seismic images, the system can reduce the domain gap between the training data (e.g., the synthetic seismic images) and the testing data (e.g., the real seismic images) of the seismic data analysis model. Thus, the seismic data analysis model can generate more accurate seismic data analysis results, e.g., a fault segmentation result, by processing the processed real seismic data item that is similar to a synthetic seismic data item.

For example, the realistic seismic image can have a high level of noise and the synthetic seismic image can be noiseless or can have a low level of noise. The system can reduce or remove the noise in the realistic seismic image. The system can process the processed realistic seismic image that has low level of noise using a fault segmentation model trained on low noise synthetic seismic images. The system can generate more accurate fault segmentation results because the input to the fault segmentation model has a similar appearance as the training examples that are used in training the fault segmentation model.

In some implementations, the system can generate realistic synthetic images from synthetic images, e.g., adding noise. In some implementations, the system can generate realistic synthetic images from real images, e.g., removing noise. The system can train a seismic data analysis model on the realistic synthetic images. After training, the trained seismic data analysis model can be readily applied to real seismic images or pre-processed real seismic images with less noise.

This specification uses the term "configured" in connection with systems and computer program components. For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non-transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially-generated propagated signal, e.g., a machine-generated electrical, optical, or electromagnetic signal, which is generated to encode information for transmission to suitable receiver apparatus for execution by a data processing apparatus.

The term "data processing apparatus" refers to data processing hardware and encompasses all kinds of apparatus, devices, and machines for processing data, including by way of example a programmable processor, a computer, or multiple processors or computers. The apparatus can also be, or further include, off-the-shelf or custom-made parallel processing subsystems, e.g., a GPU or another kind of special-purpose processing subsystem. The apparatus can also be, or further include, special purpose logic circuitry, e.g., an FPGA (field programmable gate array) or an ASIC (application-specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program which may also be referred to or described as a program, software, a software application, an app, a module, a software module, a script, or code) can be written in any form of programming language, including compiled or interpreted languages, or declarative or procedural languages, and it can be deployed in any form, including as a stand-alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub-programs, or portions of code. A computer program can be deployed to be executed on one computer or on multiple computers that are located at one site or distributed across multiple sites and interconnected by a data communication network.

As used in this specification, an "engine," or "software engine," refers to a software implemented input/output system that provides an output that is different from the input. An engine can be an encoded block of functionality, such as a library, a platform, a software development kit ("SDK"), or an object. Each engine can be implemented on any appropriate type of computing device, e.g., servers, mobile phones, tablet computers, notebook computers, music players, e-book readers, laptop or desktop computers, PDAs, smart phones, or other stationary or portable devices, that includes one or more processors and computer readable media. Additionally, two or more of the engines may be implemented on the same computing device, or on different computing devices.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read-only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer-readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and pointing device, e.g., a mouse, trackball, or a presence sensitive display or other surface by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser. Also, a computer can interact with a user by sending text messages or other forms of message to a personal device, e.g., a smartphone, running a messaging application, and receiving responsive messages from the user in return.

While this specification contains many specific implementation details, these should not be construed as limitations on the scope of the invention, which is defined by the appended claims, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In some cases, multitasking and parallel processing may be advantageous.

## Claims

1. A computer implemented method (300), comprising:
obtaining (302) a plurality of synthetic seismic data items (204), wherein each synthetic seismic data item has been generated with a respective combination of values for one or more parameters (202) of a synthetic seismic data generator (122), wherein the one or more parameters of the synthetic seismic data generator comprise geological parameters;
obtaining (304) a plurality of real seismic data items (206);
processing (306) each of the plurality of synthetic seismic data items using a machine learning model (208), wherein the machine learning model is configured to process an input seismic data item to generate an embedding;
processing (308) each of the plurality of real seismic data items using the same machine learning model;
determining (310) a range for the values for the one or more parameters by comparing the synthetic seismic data items and the real seismic data items in an embedding space of the machine learning model; and
selecting (312), as realistic synthetic seismic data items, a plurality of synthetic seismic data items that have been generated with a respective combination of values for the one or more parameters that is within the determined range.

2. The method of claim 1, wherein selecting, as the realistic synthetic seismic data items, the plurality of synthetic seismic data items that have been generated with the respective combination of values for the one or more parameters that is within the determined range comprises:
selecting, as the realistic synthetic seismic data items, from the obtained plurality of synthetic seismic data items, the plurality of synthetic seismic data items that have been generated with the respective combination of values for the one or more parameters that is within the determined range.

3. The method of claim 1, wherein selecting, as the realistic synthetic seismic data items, the plurality of synthetic seismic data items that have been generated with the respective combination of values for the one or more parameters that is within the determined range comprises:
generating, as the realistic synthetic seismic data items, new synthetic seismic data items using the synthetic seismic data generator by setting the respective combination of values for the one or more parameters within the determined range.

4. The method of claim 1, wherein determining the range for the values of the one or more parameters comprises determining the range, wherein a distance between an embedding of a synthetic seismic data item generated with a respective combination of values for the one or more parameters that is within the range and an embedding of a real seismic data item is smaller than a threshold.

5. The method of claim 1, wherein determining the range for the values for the one or more parameters comprises determining the range based on one or more earth properties of the plurality of real seismic data items.

6. The method of claim 1, further comprising: before processing each of the plurality of real seismic data items using the machine learning model, processing the plurality of real seismic data items such that the plurality of real seismic data items appear to be data items drawn from a distribution of synthetic seismic data items, wherein the processing comprises: perform a signal or image processing process to remove noise; applying an operator to straighten lines in the real seismic data items; performing a signal processing operation to reduce amplitude variations in the real seismic data items; and/or minimizing or eliminating migration artifacts in the real seismic data items.

7. The method of claim 1, further comprising: before processing each of the plurality of synthetic seismic data items using the machine learning model, processing the plurality of synthetic seismic data items such that the plurality of synthetic seismic data items appear to be data items drawn from a distribution of real seismic data items, wherein the processing comprises: migrating the synthetic seismic data items by using realistic apposition parameters; performing image processing or computer vision algorithms on the synthetic seismic data items to add noise, change noise pattern, or add artifacts; and/or using a neural network that has been trained to make a synthetic seismic data item look like a real seismic data item.

8. The method of claim any of claims 1-7, further comprising: training a seismic data analysis model on the realistic synthetic seismic data items, wherein the realistic synthetic seismic data items generated by the synthetic seismic data generator are associated with respective labels.

9. The method of claim 8, wherein the seismic data analysis model analyzes one or more earth properties, including: faults, channels, facies, and horizons.

10. The method of claim 8, further comprising: training the seismic data analysis model on: (i) the realistic synthetic seismic data items and the respective labels; and (ii) a plurality of real seismic data items, wherein the plurality of real seismic data items do not have labels.

11. The method of any of claims 1-7, further comprising: training the machine learning model using the plurality of the synthetic seismic data items and the plurality of real seismic data items.

12. The method of any of claims 1-7, wherein the machine learning model is an encoder of an autoencoder, wherein the autoencoder comprises the encoder that processes the input seismic data item to generate the embedding, and a decoder that processes the embedding to regenerate the input seismic data item.

13. The method of any of claims 1-7, wherein selecting, as the realistic synthetic seismic data items, the plurality of synthetic seismic data items that have been generated with the respective combination of values for the one or more parameters that is within the determined range comprises:
selecting the plurality of synthetic seismic data items using a reinforcement learning model.

14. A system comprising one or more computers and one or more storage devices storing instructions that when executed by the one or more computers cause the one or more computers to perform operations comprising a method according to any preceding claim.

15. One or more non-transitory computer-readable storage media storing instructions that when executed by one or more computers cause the one or more computers to perform operations comprising a method according to any of claims 1 to 13.

## Patentansprüche

1. Computerimplementiertes Verfahren (300), umfassend:
das Erhalten (302) einer Vielzahl von synthetischen seismischen Datenelementen (204), wobei jedes synthetische seismische Datenelement mit einer jeweiligen Kombination von Werten für einen oder mehrere Parameter (202) eines Generators (122) synthetischer seismischer Daten erzeugt worden ist, wobei der eine oder die mehreren Parameter des Generators synthetischer seismischer Daten geologische Parameter umfassen;
das Erhalten (304) einer Vielzahl von realen seismischen Datenelementen (206);
das Verarbeiten (306) jeder der Vielzahl von synthetischen seismischen Datenelementen unter Nutzung eines Maschinenlernmodells (208), wobei das Maschinenlernmodell konfiguriert ist, ein eingegebenes seismisches Datenelement zu verarbeiten, um eine Einbettung zu erzeugen;
das Verarbeiten (308) jeder der Vielzahl von realen seismischen Datenelementen unter Nutzung desselben Maschinenlernmodells;
das Ermitteln (310) eines Bereichs für die Werte des einen oder der mehreren Parameter durch Vergleichen der synthetischen seismischen Datenelemente und der realen seismischen Datenelemente in einem Einbettungsraum des Maschinenlernmodells; und
das Auswählen (312) einer Vielzahl von synthetischen seismischen Datenelementen, die mit einer jeweiligen Kombination von Werten für den einen oder die mehreren Parameter erzeugt worden sind, die innerhalb des bestimmten Bereichs liegt, als realistische synthetische seismische Datenelemente.

2. Das Verfahren nach Anspruch 1, wobei das Auswählen, als die realistischen synthetischen seismischen Datenelemente, der Vielzahl von synthetischen seismischen Datenelementen, die mit der jeweiligen Kombination von Werten für den einen oder die mehreren Parameter erzeugt worden sind, wobei die jeweilige Kombination innerhalb des bestimmten Bereichs liegt, umfasst:
das Auswählen, als die realistischen synthetischen seismischen Datenelemente, aus der erhaltenen Vielzahl von synthetischen seismischen Datenelementen, der Vielzahl von synthetischen seismischen Datenelementen, die mit der jeweiligen Kombination von Werten für den einen oder die mehreren Parameter erzeugt worden sind, wobei die jeweilige Kombination innerhalb des bestimmten Bereichs liegt.

3. Das Verfahren nach Anspruch 1, wobei das Auswählen, als die realistischen synthetischen seismischen Datenelemente, der Vielzahl von synthetischen seismischen Datenelementen, die mit der jeweiligen Kombination von Werten für den einen oder die mehreren Parameter erzeugt worden sind, wobei die jeweilige Kombination innerhalb des bestimmten Bereichs liegt, umfasst:
das Erzeugen, als die realistischen synthetischen seismischen Datenelemente, neuer synthetischer seismischer Datenelemente unter Nutzung des Generators synthetischer seismischer Daten durch Einstellen der jeweiligen Kombination von Werten für den einen oder die mehreren Parameter innerhalb des bestimmten Bereichs.

4. Das Verfahren nach Anspruch 1, wobei das Ermitteln des Bereichs für die Werte des einen oder der mehreren Parameter umfasst, den Bereich zu ermitteln, wobei ein Abstand zwischen einer Einbettung eines synthetischen seismischen Datenelements, das mit einer jeweiligen Kombination von Werten für den einen oder die mehreren Parameter erzeugt worden ist, wobei die jeweilige Kombination innerhalb des Bereichs liegt, und einer Einbettung eines realen seismischen Datenelements kleiner als ein Schwellenwert ist.

5. Das Verfahren nach Anspruch 1, wobei das Ermitteln des Bereichs für die Werte des einen oder der mehreren Parameter umfasst, den Bereich basierend auf einer oder mehreren Erdeeigenschaften der Mehrzahl realer seismischer Datenelemente zu ermitteln.

6. Das Verfahren nach Anspruch 1, ferner umfassend: vor dem Verarbeiten jeder der Vielzahl von realen seismischen Datenelementen unter Nutzung des Maschinenlernmodells, Verarbeiten der Vielzahl von realen seismischen Datenelementen derart, dass die Vielzahl von realen seismischen Datenelementen als Datenelemente erscheinen, die aus einer Verteilung synthetischer seismischer Datenelemente stammen, wobei das Verarbeiten umfasst: das Durchführen eines Signal- oder Bildverarbeitungsprozesses zum Entfernen von Rauschen; das Anwenden eines Operators zum Begradigen von Linien in den realen seismischen Datenelementen; das Durchführen einer Signalverarbeitungsoperation zum Reduzieren von Amplitudenvariationen in den realen seismischen Datenelementen; und/oder das Minimieren oder das Eliminieren von Migrationsartefakten in den realen seismischen Datenelementen.

7. Das Verfahren nach Anspruch 1, ferner umfassend: vor dem Verarbeiten jeder der Vielzahl von synthetischen seismischen Datenelementen unter Nutzung des Maschinenlernmodells, das Verarbeiten der Vielzahl von synthetischen seismischen Datenelementen derart, dass die Vielzahl von synthetischen seismischen Datenelementen als Datenelemente erscheinen, die aus einer Verteilung realer seismischer Datenelemente stammen, wobei das Verarbeiten umfasst: das Migrieren der synthetischen seismischen Datenelemente unter Nutzung realistischer Aperturparameter; das Durchführen von Bildverarbeitungs- oder Computer-Vision-Algorithmen an den synthetischen seismischen Datenelementen, um Rauschen hinzuzufügen, ein Rauschmuster zu ändern oder Artefakte hinzuzufügen; und/oder das Verwenden eines neuronalen Netzwerks, das trainiert worden ist, ein synthetisches seismisches Datenelement wie ein reales seismisches Datenelement erscheinen zu lassen.

8. Das Verfahren nach einem der Ansprüche 1 bis 7, ferner umfassend: das Trainieren eines Modells zur Analyse seismischer Daten anhand der realistischen synthetischen seismischen Datenelemente, wobei die von dem Generator synthetischer seismischer Daten erzeugten realistischen synthetischen seismischen Datenelemente jeweiligen Labels zugeordnet sind.

9. Das Verfahren nach Anspruch 8, wobei das Modell zur Analyse seismischer Daten eine oder mehrere Erdeigenschaften analysiert, darunter: Verwerfungen, Kanäle, Fazies und Horizonte.

10. Das Verfahren nach Anspruch 8, ferner umfassend: das Trainieren des Modells zur Analyse seismischer Daten unter Verwendung von: (i) den realistischen synthetischen seismischen Datenelementen und den jeweiligen Labels; und (ii) einer Vielzahl von realen seismischen Datenelementen, wobei die realen seismischen Datenelemente nicht mit Labels versehen sind.

11. Das Verfahren nach einem der Ansprüche 1 bis 7, ferner umfassend: das Trainieren des Maschinenlernmodells unter Nutzung der Vielzahl von synthetischen seismischen Datenelementen und der Vielzahl von realen seismischen Datenelementen.

12. Das Verfahren nach einem der Ansprüche 1 bis 7, wobei das Maschinenlernmodell ein Encoder eines Autoencoders ist, wobei der Autoencoder den Encoder, der das seismische Eingabedatenelement verarbeitet, um die Einbettung zu erzeugen, und einen Decoder umfasst, der die Einbettung verarbeitet, um das seismische Eingabedatenelement wiederzuerzeugen.

13. Das Verfahren nach einem der Ansprüche 1 bis 7, wobei das Auswählen, als die realistischen synthetischen seismischen Datenelemente, der Vielzahl von synthetischen seismischen Datenelementen, die mit der jeweiligen Kombination von Werten für den einen oder die mehreren Parameter erzeugt worden sind, wobei die jeweilige Kombination innerhalb des bestimmten Bereichs liegt, umfasst:
das Auswählen der Vielzahl von synthetischen seismischen Datenelementen unter Nutzung eines Reinforcement-Learning-Modells.

14. Ein System, umfassend einen oder mehrere Computer und eine oder mehrere Speichervorrichtungen, die Anweisungen speichern, die bei Ausführung durch den einen oder die mehreren Computern, den einen oder die mehreren Computer veranlassen, Operationen durchzuführen, die ein Verfahren nach einem der vorhergehenden Ansprüche umfassen.

15. Ein oder mehrere nichttransitorische computerlesbare Speichermedien, auf denen Anweisungen gespeichert sind, die bei Ausführung durch einen oder mehrere Computer den einen oder die mehreren Computer veranlassen, Operationen durchzuführen, die ein Verfahren nach einem der Ansprüche 1 bis 13 umfassen.

## Revendications

1. Procédé mis en œuvre par ordinateur (300) comprenant :
l'obtention (302) d'une pluralité d'éléments de données sismiques de synthèse (204), dans lequel chaque élément de données sismiques de synthèse a été généré avec une combinaison respective de valeurs pour un ou plusieurs paramètres (202) d'un générateur de données sismiques de synthèse (122), dans lequel les un ou plusieurs paramètres du générateur de données sismiques de synthèse comprennent des paramètres géologiques ;
l'obtention (304) d'une pluralité d'éléments de données sismiques réels (206) ;
le traitement (306) de chacun de la pluralité d'éléments de données sismiques de synthèse à l'aide d'un modèle d'apprentissage automatique (208), dans lequel le modèle d'apprentissage automatique est configuré pour traiter un élément de données sismiques d'entrée afin de générer une intégration ;
le traitement (308) de chacun des éléments de la pluralité d'éléments de données sismiques réels à l'aide du même modèle d'apprentissage automatique ;
la détermination (310) d'une plage pour les valeurs des un ou plusieurs paramètres en comparant les éléments de données sismiques de synthèse et les éléments de données sismiques réels dans un espace d'intégration du modèle d'apprentissage automatique ; et
la sélection (312), en tant qu'éléments de données sismiques de synthèse réalistes, d'une pluralité d'éléments de données sismiques de synthèse qui ont été générés avec une combinaison respective de valeurs pour les un ou plusieurs paramètres qui sont au sein de la plage déterminée.

2. Procédé selon la revendication 1, dans lequel la sélection, en tant que les éléments de données sismiques de synthèse réalistes, de la pluralité d'éléments de données sismiques de synthèse qui ont été générés avec la combinaison respective de valeurs pour les un ou plusieurs paramètres qui sont au sein de la plage déterminée, comprend :
la sélection, en tant que les éléments de données sismiques de synthèse réalistes, à partir de la pluralité obtenue d'éléments de données sismiques de synthèse, de la pluralité d'éléments de données sismiques de synthèse qui ont été générés avec la combinaison respective de valeurs pour les un ou plusieurs paramètres qui sont au sein de la plage déterminée.

3. Procédé selon la revendication 1, dans lequel la sélection, en tant que les éléments de données sismiques de synthèse réalistes, de la pluralité d'éléments de données sismiques de synthèse qui ont été générés avec la combinaison respective de valeurs pour les un ou plusieurs paramètres qui sont au sein de la plage déterminée, comprend :
la génération, en tant que les éléments de données sismiques de synthèse réalistes, de nouveaux éléments de données sismiques de synthèse à l'aide du générateur de données sismiques de synthèse en réglant la combinaison respective de valeurs pour les un ou plusieurs paramètres au sein de la plage déterminée.

4. Procédé selon la revendication 1, dans lequel la détermination de la plage pour les valeurs des un ou plusieurs paramètres comprend la détermination de la plage, dans lequel une distance entre une intégration d'un élément de données sismiques de synthèse généré avec une combinaison respective de valeurs pour les un ou plusieurs paramètres qui est au sein de la plage et une intégration d'un élément de données sismiques réel est inférieure à un seuil.

5. Procédé selon la revendication 1, dans lequel la détermination de la plage pour les valeurs des un ou plusieurs paramètres comprend la détermination de la plage sur la base d'une ou plusieurs propriétés terrestres de la pluralité d'éléments de données sismiques réels.

6. Procédé selon la revendication 1, comprenant en outre : avant le traitement de chacun de la pluralité d'éléments de données sismiques réels à l'aide du modèle d'apprentissage automatique, le traitement de la pluralité d'éléments de données sismiques réels de telle sorte que la pluralité d'éléments de données sismiques réels apparaissent comme étant des éléments de données tirés d'une distribution d'éléments de données sismiques de synthèse, dans lequel le traitement comprend : la réalisation d'un processus de traitement de signal ou d'image pour supprimer le bruit ; l'application d'un opérateur pour redresser des lignes dans les éléments de données sismiques réels ; la réalisation d'une opération de traitement de signal pour réduire les variations d'amplitude dans les éléments de données sismiques réels ; et/ou la réduction au minimum ou l'élimination d'artefacts de migration dans les éléments de données sismiques réels.

7. Procédé selon la revendication 1, comprenant en outre : avant le traitement de chacun de la pluralité d'éléments de données sismiques de synthèse à l'aide du modèle d'apprentissage automatique, le traitement de la pluralité d'éléments de données sismiques de synthèse de telle sorte que la pluralité d'éléments de données sismiques de synthèse apparaissent comme étant des éléments de données tirés d'une distribution d'éléments de données sismiques réels, dans lequel le traitement comprend : la migration des éléments de données sismiques de synthèse à l'aide de paramètres d'apposition réalistes ; la réalisation d'algorithmes de traitement d'image ou de vision par ordinateur sur les éléments de données sismiques de synthèse pour ajouter du bruit, changer le motif de bruit, ou ajouter des artefacts ; et/ou l'utilisation d'un réseau neuronal qui a été entraîné pour faire en sorte qu'un élément de données sismiques de synthèse ressemble à un élément de données sismiques réel.

8. Procédé selon l'une quelconque des revendications 1 à 7, comprenant en outre : l'entraînement d'un modèle d'analyse de données sismiques sur les éléments de données sismiques de synthèse réalistes, dans lequel les éléments de données sismiques de synthèse réalistes générés par le générateur de données sismiques de synthèse sont associés à des étiquettes respectives.

9. Procédé selon la revendication 8, dans lequel le modèle d'analyse de données sismiques analyse une ou plusieurs propriétés terrestres, incluant : des failles, des canaux, des faciès et des horizons.

10. Procédé selon la revendication 8, comprenant en outre : l'entraînement du modèle d'analyse de données sismiques sur : (i) les éléments de données sismiques de synthèse réalistes et les étiquettes respectives ; et (ii) une pluralité d'éléments de données sismiques réels, dans lequel la pluralité d'éléments de données sismiques réels ne possède pas d'étiquettes.

11. Procédé selon l'une quelconque des revendications 1 à 7, comprenant en outre : l'entraînement du modèle d'apprentissage automatique en utilisant la pluralité d'éléments de données sismiques de synthèse et la pluralité d'éléments de données sismiques réels.

12. Procédé selon l'une quelconque des revendications 1 à 7, dans lequel le modèle d'apprentissage automatique est un codeur d'un autocodeur, dans lequel l'autocodeur comprend le codeur qui traite l'élément de données sismiques d'entrée afin de générer l'intégration, et un décodeur qui traite l'intégration pour régénérer l'élément de données sismiques d'entrée.

13. Procédé selon l'une quelconque des revendications 1 à 7, dans lequel la sélection, en tant que les éléments de données sismiques de synthèse réalistes, de la pluralité d'éléments de données sismiques de synthèse qui ont été générés avec la combinaison respective de valeurs pour les un ou plusieurs paramètres qui sont au sein de la plage déterminée, comprend :
la sélection de la pluralité d'éléments de données sismiques de synthèse à l'aide d'un modèle d'apprentissage par renforcement.

14. Système comprenant un ou plusieurs ordinateurs et un ou plusieurs dispositifs de stockage stockant des instructions qui, lorsqu'elles sont exécutées par les un ou plusieurs ordinateurs, amènent les un ou plusieurs ordinateurs à réaliser des opérations comprenant un procédé selon une quelconque revendication précédente.

15. Un ou plusieurs supports de stockage non transitoires lisibles sur ordinateur stockant des instructions qui, lorsqu'elles sont exécutées par un ou plusieurs ordinateurs, amènent les un ou plusieurs ordinateurs à réaliser des opérations comprenant un procédé selon l'une quelconque des revendications 1 à 13.
